# DEMANDE DE BREVET EUROPEEN

(11) **EP 2 337 076 A1**
(43) Date de publication de la demande: **22.06.2011**
(21) Numéro de dépôt: 10194308.2
(22) Date de dépôt: 09.12.2010
(51) Int. Cl.: H01L 27/146

(54) **Dispositif microélectronique, en particulier capteur d'image à illumination par la face arrière et procédé de fabrication.**

(30) Priorité: 16.12.2009 FR 0959060
(71) Demandeur: STmicroelectronics SA, 92120 Montrouge (FR); STMicroelectronics (Crolles 2) SAS, 38920 Crolles (FR)
(72) Inventeur: Marty, Michel, 38760, VARCES (FR); Dutartre, Didier, 38240, MEYLAN (FR); Roy, François, 38180, SEYSSINS (FR); Besson, Pascal, 38220, NOTRE DAME DE MESSAGE (FR); Prima, Jens, 38700, LA TRONCHE (FR)
(74) Mandataire: Zapalowicz, Francis

(57) **Abrégé**

Procédé de réalisation d'un dispositif microélectronique comprenant une réalisation d'un premier substrat (1) semiconducteur comportant une formation d'une première couche (5) et d'une deuxième couche (4) entre une première face (7) et une deuxième face (2) du substrat, une réalisation de premiers composants (10) et d'une partie d'interconnexion au niveau et au dessus de la deuxième face (2), un amincissement du substrat comprenant une première gravure sélective du premier substrat depuis la première face (7) avec arrêt sur la première couche (5) suivie d'une deuxième gravure sélective avec arrêt sur la deuxième couche (4).

## Description

L'invention se rapporte au domaine de la microélectronique et plus particulièrement aux dispositifs optoélectroniques à illumination en face arrière ainsi qu'à leur réalisation.

Les substrats de type silicium sur isolant (en langue anglaise, Silicon On Insulator, acronyme SOI) remplacent les substrats classiques en silicium lors de la réalisation d'un certain nombre de dispositifs, notamment dans le domaine des micro-ondes et des transistors. Ces substrats sont issus d'un procédé complexe impliquant une implantation d'hydrogène dans le substrat suivi d'un traitement haute température pour créer une zone de faiblesse dans le cristal. Le substrat ainsi traité est ensuite collé par adhésion moléculaire sur un autre substrat avant le clivage dans la zone de faiblesse créée par l'implantation d'hydrogène. On obtient alors un sandwich avec le substrat composé de silicium, d'oxyde de silicium et de silicium dans lequel les dispositifs pourront être réalisés, tout en étant isolés du substrat. L'épaisseur de silicium dans laquelle sont fabriqués les dispositifs est limitée par la profondeur à laquelle est implanté l'hydrogène afin de créer la zone de clivage. La qualité du silicium est celle du substrat initial dans lequel est implanté l'hydrogène. La qualité du nouveau substrat ainsi collé est celle du support sur lequel a été reporté le substrat implanté. Le procédé de réalisation permet d'obtenir des couches cristallines sans défauts et une interface avec l'oxyde d'isolation de bonne qualité.

Apres report, une épitaxie de silicium peut être faite en surface de la couche de silicium, pour ajuster l'épaisseur de la couche de silicium dans laquelle seront fabriqués ensuite les dispositifs. La couche d'oxyde étant employée comme isolation et/ou comme couche d'arrêt des étapes de gravure du substrat. Malgré leurs avantages indéniables, de tels substrats présentent un coût plus élevé que les substrats classiques.

Par ailleurs, les dispositifs microélectroniques d'imagerie de type CMOS voient une constante et forte augmentation de leur marché. Le défi de cette technologie est de diminuer la taille des pixels sans diminuer leurs performances. Deux technologies sont actuellement en compétition, la technologie FSI (acronyme anglais pour Front Side Illumination) et la technologie BSI (acronyme anglais pour Back Side Illumination). La technologie FSI consiste à illuminer le dispositif par la face avant au travers des couches du back end, c'est-à-dire la face sur laquelle sont situés les photodiodes ou phototransistors surmontée des couches d'interconnection du circuit. La technologie BSI consiste à illuminer le dispositif par sa face arrière, le rayonnement étant directement absorbé par le substrat silicium.

Les deux technologies présentent des avantages et inconvénients. La technologie BSI permet de contrôler plus facilement les effets liés à la photogénération (cross talk, rendement quantique) et de s'affranchir des réflexions parasites induites par les lignes de métal. La technologie BSI est donc mieux adaptée à la fabrication de pixels de petites dimensions. Actuellement, la technologie BSI est balbutiante, et réalisée à partir de substrats SOI précédemment décrits. Ces substrats particulièrement coûteux, freinent le développement technologique et commercial de tels dispositifs microélectroniques.

Selon un mode de mise en oeuvre et de réalisation, il est proposé une réalisation d'un substrat aminci recouvert d'une couche superficielle en SiGe, permettant une réalisation d'un capteur d'image CMOS destiné à être illuminé par la face arrière.

Selon un autre mode de mise en oeuvre et de réalisation, il est proposé une réalisation d'un tel capteur à partir d'un substrat massif (« bulk », selon une dénomination habituellement utilisée par l'homme du métier) aminci par des gravures sélectives successives permettant d'obtenir une épaisseur homogène et contrôlée sur l'ensemble de la plaque semiconductrice (« wafer »).

Selon un aspect, il est proposé un procédé de réalisation d'un dispositif microélectronique comprenant une réalisation d'un premier substrat semiconducteur comportant une formation d'une première couche, par exemple du silicium Si dopé P++, et d'une deuxième couche, par exemple du silicium germanium SiGe, entre une première face et une deuxième face du substrat, une réalisation de premiers composants et d'une partie d'interconnexion au niveau et au dessus de la deuxième face, un amincissement du substrat comprenant une première gravure sélective du premier substrat depuis la première face avec arrêt sur la première couche suivie d'une deuxième gravure sélective avec arrêt sur la deuxième couche.

L'amincissement du substrat permet notamment une illumination face arrière d'un capteur d'image réalisé dans et sur ce substrat.

La première gravure sélective, de préférence chimique, permet de diminuer les inhomogénéités en épaisseur du substrat tandis que la deuxième gravure sélective (par exemple chimique ou plasma), permet d'obtenir l'épaisseur désirée et contrôlée de silicium.

La réalisation du premier substrat comporte de préférence une épitaxie de la première couche sur un substrat initial, par exemple un substrat massif en silicium dopé P⁻, une épitaxie de la deuxième couche sur la première couche et une épitaxie d'une couche semiconductrice finale, par exemple du silicium Si dopé P⁻ ou Si dopé N⁻, sur la deuxième couche.

L'épitaxie de la couche semiconductrice finale peut s'effectuer sur une épaisseur comprise entre environ 2µm et 6µm. Cette épaisseur est l'épaisseur de la couche semiconductrice à travers laquelle seront par exemple illuminées les photodiodes du capteur d'image. La réalisation des premiers composants peut comprendre la réalisation de composants tels que des photodiodes, et des transistors MOS.

L'épitaxie de la deuxième couche peut comprendre une épitaxie de SiGe. La couche de SiGe, conservée au moins partiellement après l'amincissement, sert de canal pour les électrons de manière à diminuer, voire supprimer le courant d'obscurité du capteur d'image.

L'épitaxie de la première couche peut comprendre une épitaxie de Si dopé P++.

Une épitaxie intermédiaire de silicium P- peut être rajoutée entre la couche de silicium P++ et la couche de SiGe et permet d'augmenter la sélectivité de gravure entre les couches de silicium dopé P et le SiGe.

Le procédé peut comprendre, avant l'amincissement du substrat, un enrobage des premiers composants et de la partie d'interconnexion avec au moins un matériau isolant, et une fixation d'un deuxième substrat sur l'enrobage de matériau isolant.

Le procédé peut comprendre, après la deuxième gravure, un dépôt d'une couche de passivation sur la deuxième couche. Cette couche de passivation forme ainsi la face arrière d'un capteur d'image.

Le procédé peut comprendre, une réalisation de deuxièmes composants sur la couche de passivation, par exemple des lentilles et des filtres colorés.

La première couche peut présenter une sélectivité de gravure vis-à-vis de la deuxième couche comprise entre 30 et 500, de préférence entre 60 et 100.

Selon un autre aspect, il est proposé un dispositif microélectronique comprenant une couche semiconductrice, une couche superficielle formée sur une première face de la couche semiconductrice, des premiers composants et une partie d'interconnexion situés au niveau et au dessus d'une deuxième face de la couche semiconductrice.

La couche semiconductrice peut présenter une épaisseur comprise entre 2µm et 6µm.

La couche superficielle peut comprendre une couche de SiGe.

Les premiers composants peuvent comprendre des composants optoélectroniques, par exemple des photodiodes, destinés à être illuminés à travers la couche semiconductrice et la couche superficielle.

Les premiers composants et la partie d'interconnexion peuvent être enrobés dans au moins un matériau isolant, un deuxième substrat étant fixé sur l'enrobage isolant.

Le dispositif microélectronique peut comprendre une couche de passivation sur la couche superficielle.

Le dispositif microélectronique peut comprendre des deuxièmes composants sur la couche de passivation.

Les deuxièmes composants peuvent comprendre des composants optiques, par exemple des microlentilles et/ou des filtres colorés.

Selon un autre aspect, il est proposé un capteur d'image comprenant un dispositif microélectronique tel que défini ci-avant, destiné à être illuminé par la face arrière.

Selon un mode de réalisation, un tel capteur d'image présente l'avantage d'être réalisé en deux étapes. La première étape permet de réduire les inhomogénéités d'épaisseur de la partie CMOS par le meulage du substrat de silicium massif (« bulk ») jusqu'à une épaisseur sous le CMOS de 5 à 10µm, puis par attaque sélective (de préférence chimique) du silicium dopé P- avec arrêt dans la couche de silicium dopé P++. La deuxième étape permet d'obtenir l'épaisseur désirée et contrôlée de silicium sous le CMOS grâce à une attaque très sélective, notamment chimique ou plasma, de la couche de silicium P++ avec arrêt sur la couche de SiGe.

Selon un mode de réalisation, un tel capteur d'image présente également l'avantage de conserver une couche de SiGe après l'étape d'amincissement, ce qui permet de disposer d'un canal pour les électrons de manière à diminuer ou supprimer le courant d'obscurité.

D'autres buts, caractéristiques et avantages apparaîtront à la lecture de la description suivante donnée uniquement en tant qu'exemple non limitatif et faite en référence aux dessins annexés sur lesquels :
- les figures 1 à 9 illustrent un mode de mise en oeuvre d'un procédé de réalisation d'un dispositif microélectronique selon l'invention ; et
- la figure 10 illustre un mode de réalisation d'un capteur d'image incorporant un mode de réalisation d'un dispositif microélectronique selon l'invention.

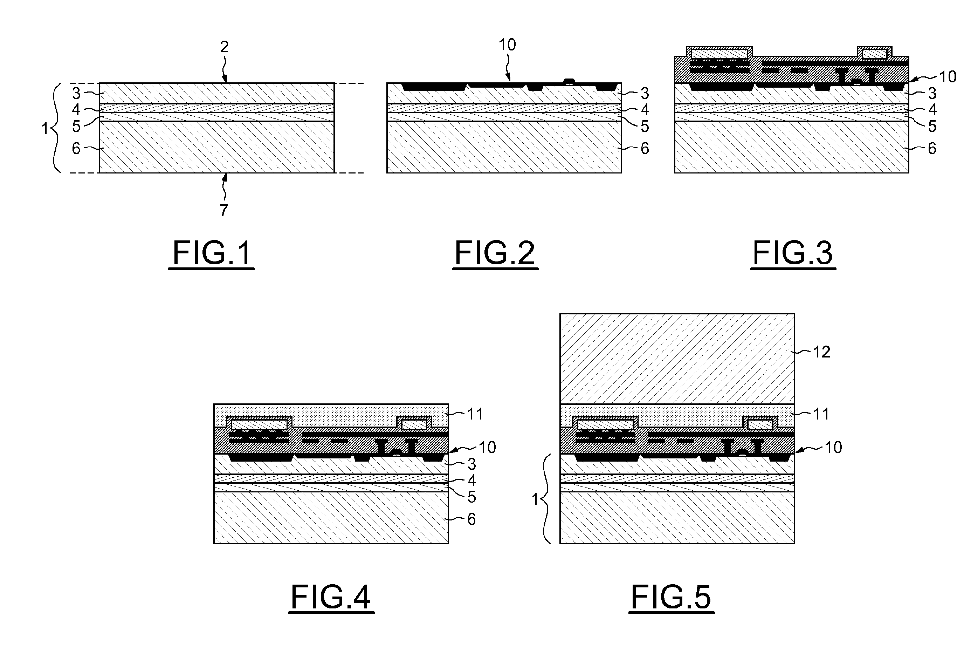

Sur la figure 1, la référence 1 désigne un premier substrat semi-conducteur utilisé dans un mode de mise en oeuvre d'un procédé de réalisation d'un dispositif microélectronique selon l'invention.

Pour obtenir ce premier substrat 1, on réalise une première couche 5 sur un substrat de silicium 6, par exemple du silicium dopé P⁺. On réalise ensuite une deuxième couche 4 sur la première couche 5, puis une couche semi-conductrice finale 3 sur la deuxième couche 4.

La réalisation de la première couche 5, de la deuxième couche 4, et de la couche semi-conductrice finale 3 peuvent résulter d'une épitaxie.

Les épaisseurs épitaxiées sont dépendantes des sélectivités et des tolérances lors de la gravure. Plus une sélectivité sera grande, plus l'épaisseur de la couche d'arrêt pourra être faible par rapport à l'épaisseur de la couche gravée. Une mention particulière doit être faite concernant l'épitaxie de la couche semi-conductrice finale. En effet, les composants du dispositif sont destinés à être réalisés sur les faces de la couche semi-conductrice finale après l'étape d'amincissement. L'épaisseur de la couche semi-conductrice finale détermine ainsi l'épaisseur de silicium dans le dispositif à l'issue du procédé de réalisation. On réalise généralement une épitaxie comprise entre environ 2µm et 6µm.

De même, on choisit les matériaux compris dans la première couche 5 et dans la deuxième couche 4 de sorte qu'il existe une différence de vitesses de gravure entre la première couche 5 et le substrat de silicium 6 et entre la première couche 5 et la deuxième couche 4. Les différences de vitesses de gravure sont généralement appelées sélectivités.

Par le choix des matériaux, on cherche, lors de la deuxième étape, à obtenir une gravure plus rapide du substrat de silicium 6 que de la première couche 5, dont la gravure est elle-même plus rapide que celle de la deuxième couche 4. Pour obtenir de telles sélectivités, on choisit par exemple un silicium fortement dopé P++ de l'ordre de 5.10¹⁹ cm⁻³ à 2.10²⁰ cm⁻³comme matériau de la première couche 5 et du SiGe comme matériau de la deuxième couche 4. On choisit généralement une sélectivité de gravure entre la première couche et la deuxième couche comprise entre 30 et 500, de préférence entre 60 et 100.

Dans une application d'imagerie, les épaisseurs et le dopage des couches épitaxiées P++ et SiGe sont déterminés de manière à assurer un champ électrique latéral sous la photodiode (« drift »).

A titre indicatif, l'épaisseur de la couche P++ est comprise entre 1 et 2 µm, tandis que l'épaisseur de la couche SiGe est comprise entre 20 et 50 nm.

Le premier substrat semi-conducteur 1 ainsi obtenu comprend une première face 7 confondue avec la surface inférieure du substrat de silicium 6 et une deuxième face 2 confondue avec la surface supérieure la couche semi-conductrice finale 3.

Au cours d'une deuxième étape (figures 2 et 3), on réalise un ensemble de premiers composants 10 sur et dans la deuxième face 2. Sur la figure 2, on peut voir la réalisation de premiers composants 10 du dispositif électronique sur la deuxième face 2 du substrat. Ces composants peuvent être par exemple des transistors de type CMOS et/ou des photodiodes. Sur la figure 3, on peut voir la réalisation de niveaux d'interconnexion permettant de relier les premiers composants entre eux, ainsi que de préparer des zones comprises dans des vias de connexion à l'issue du procédé de réalisation.

Les premiers composants 10 et la zone d'interconnexion sont alors enrobés d'un matériau isolant 11. Ce matériau peut être un matériau diélectrique employé en microélectronique, par exemple un oxyde ou un nitrure de silicium.

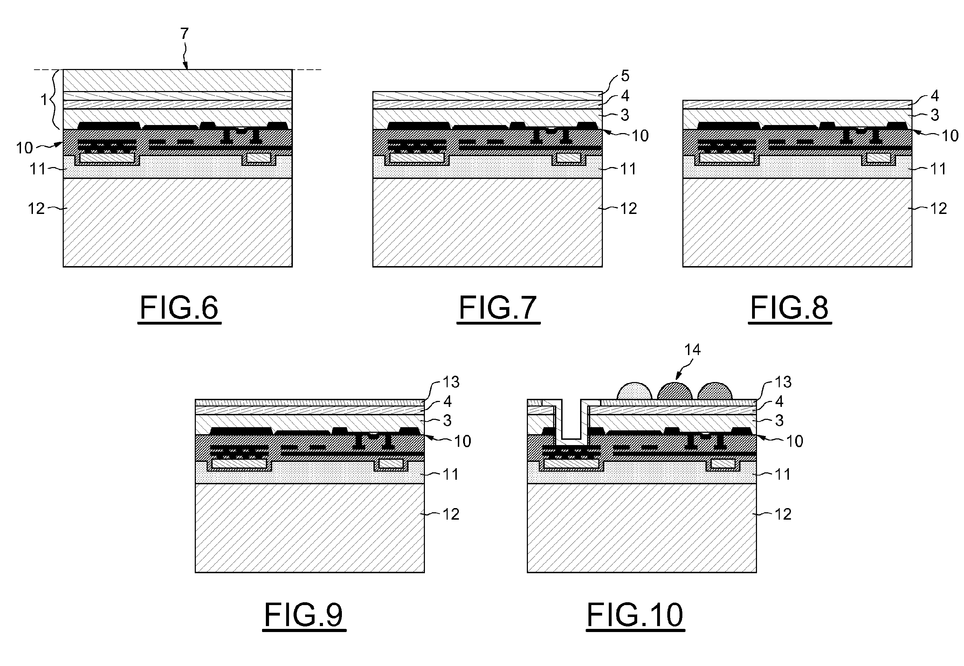

Apres une étape de planarisation non illustrée sur la figure 4, le premier substrat 1 est fixé par l'intermédiaire de l'enrobage de matériau isolant 11 à un deuxième substrat 12, par exemple par collage moléculaire. Le deuxième substrat 12 ne présente pas de caractéristique particulière en dehors de sa capacité à soutenir le premier substrat 1 de sorte que la manipulation du premier substrat 1 soit moins risquée du fait de sa faible épaisseur de l'ordre de quelques micromètres après amincissement. Le résultat obtenu est illustré par la figure 5. Le premier substrat 1 va ensuite subir une phase d'amincissement, comme illustré sur les figures 6 à 8.

Après un meulage grossier du silicium 6, on procède à une première gravure avec arrêt sur la première couche 5 qui permet de retirer complètement le substrat de silicium 6, ainsi qu'une partie de la première couche 5. La première couche 5 peut indistinctement être partiellement ou totalement retirée lors de cette première gravure. Le résultat est illustré par la figure 7.

La première gravure peut associer indistinctement une étape de gravure humide (par exemple une solution diluée de TMAH (Tetramethylammonium hydroxide) et/ou une gravure sèche de type gravure par plasma type fluoré. Le but de cette gravure est de réduire l'épaisseur du substrat à une épaisseur proche de la valeur requise pour le dispositif. Le principal intérêt de cette première gravure est une vitesse importante de gravure permettant d'obtenir rapidement l'épaisseur visée. Les variations d'épaisseur du silicium dans lequel ont été fabriqué les composants de type CMOS sont réduites par rapport à l'étape de meulage. La variation d'épaisseur totale (TTV ou « Total Thickness Variation ») est comprise entre 0.5 et 2µm selon la méthode utilisée. Cependant, le résultat obtenu n'est pas suffisant pour garantir un comportement homogène des imageurs sur l'ensemble de la plaque. Une sélectivité d'environ 10 entre les gravures de substrat 6 de silicium et de la première couche 5 en silicium dopé P++ permet d'obtenir une gravure rapide.

Le procédé se poursuit ensuite par une deuxième gravure pour retirer la matière restante à l'issue de la première gravure. La deuxième couche 4 peut indistinctement être laissée inchangée, ou partiellement ou totalement retirée lors de la deuxième gravure. Optionnellement, une couche de silicium P- peut être intercalée entre les couches 4 et 5 pour séparer les dites couches et augmenter encore la sélectivité globale du procédé. Dans ce cas, la première gravure 1 sera sélective par rapport au silicium dopé P- et une gravure additionnelle, sélective par rapport à la couche 4 sera ajoutée pour retirer sélectivement la couche de silicium dopé P- intercalée. La gravure additionnelle est de préférence une gravure humide de type HNO₃+HF.

Cela étant, dans une application d'imageur, cette deuxième couche 4 en SiGe est avantageusement au moins partiellement conservée.

La deuxième gravure est indistinctement de type gravure humide et/ou gravure sèche type plasma déporté avec un mélange de gaz par exemple du CF₄+N₂+O₂+CH₂F₂. Le but de cette gravure est de terminer la réduction de l'épaisseur du substrat à l'épaisseur requise pour le dispositif. Le principal intérêt de cette deuxième gravure est une très forte sélectivité entre la gravure de la première couche 5 de silicium et de la deuxième couche 4 de SiGe. La sélectivité est supérieure à 30. Cela permet d'obtenir une variation d'épaisseur de silicium (TTV) très faible, entre 0.05 et 0.3 µm. Le résultat de la deuxième gravure est illustré par la figure 8.

Le procédé se poursuit par la réalisation du dépôt d'une couche de passivation 13 qui peut être un oxyde de silicium d'une épaisseur comprise entre 0.05 et 0.3 µm sur la deuxième couche 4 à l'issue de la deuxième gravure. Le résultat est illustré par la figure 9.

Le procédé se termine par une réalisation classique de la deuxième partie 14 des composants du dispositif sur la couche de passivation 13. La deuxième partie 14 des composants peut comprendre des liaisons traversantes, des couches anti-reflets, des filtres et lentilles. Le résultat est illustré par la figure 10.

La figure 10 permet également d'illustrer un mode de réalisation d'un dispositif microélectronique selon l'invention.

On retrouve donc sur le dispositif de la figure 10, la couche semiconductrice 3 recouverte de la couche superficielle 4 qui est ici une couche de silicium germanium SiGe particulièrement intéressante dans le domaine du capteur d'image. En effet, cette couche qui a servi de couche d'arrêt au moment de l'amincissement du substrat a également un rôle électrique puisque, de par sa bande interdite plus faible, elle piège et recombine les électrons d'agitation thermique de l'interface avec la couche de passivation 13 (oxyde de silicium par exemple), ce qui a pour effet de diminuer le courant d'obscurité de l'imageur, c'est-à-dire le courant en absence d'éclairement.

La face supérieure de la couche de passivation, c'est-à-dire la face sur laquelle sont réalisés des composants optiques 14, tels que des filtres colorés et/ou des microlentilles, constitue la face arrière du dispositif ou capteur d'image. Ce capteur d'image va donc pouvoir être illuminé par la face arrière. A cet égard, la couche semiconductrice 3, de qualité cristalline et de faible épaisseur (typiquement comprise entre 2µm et 6µm), permet d'assurer à la fois les performances des composants CMOS, la capture des photons et le transfert des électrons au plus proche du composant.

Par ailleurs, de par la diffusion des dopants P provenant de la couche P++, on obtient sous les photodiodes un profil de dopage permettant l'obtention d'un champ électrique latéral (« drift ») non rétrograde dans le silicium facilitant le transfert des électrons.

## Revendications

1. Procédé de réalisation d'un dispositif microélectronique comprenant une réalisation d'un premier substrat (1) semiconducteur comportant une formation d'une première couche (5) et d'une deuxième couche (4) entre une première face (7) et une deuxième face (2) du substrat, une réalisation de premiers composants (10) et d'une partie d'interconnexion au niveau et au dessus de la deuxième face (2), un amincissement du substrat comprenant une première gravure sélective du premier substrat depuis la première face (7) avec arrêt sur la première couche (5) suivie d'une deuxième gravure sélective avec arrêt sur la deuxième couche (4).

2. Procédé selon la revendication 1, dans lequel la réalisation du premier substrat comporte une épitaxie de la première couche (5) sur un substrat initial, une épitaxie de la deuxième couche (4) sur la première couche (5) et une épitaxie d'une couche semiconductrice finale (3) sur la deuxième couche (4).

3. Procédé de réalisation selon la revendication 2, dans lequel la réalisation du premier substrat comporte en outre une épitaxie d'une couche de silicium intercalée entre l'épitaxie de la première couche (5) et l'épitaxie de la deuxième couche (4) du premier substrat.

4. Procédé de réalisation selon la revendication 3, dans lequel l'amincissement du premier substrat comprend une gravure additionnelle apte à retirer sélectivement la couche de silicium intercalée, effectuée entre la première et la deuxième gravure.

5. Procédé de réalisation selon l'une des revendications 2 à 4, dans lequel l'épitaxie de la couche semiconductrice finale (3) s'effectue sur une épaisseur comprise entre 2 µm et 6 µm.

6. Procédé de réalisation l'une des revendications précédentes, dans lequel la réalisation des premiers composants (10) comprend la réalisation de composants optoélectroniques.

7. Procédé de réalisation selon l'une des revendications précédentes, dans lequel l'épitaxie de la deuxième couche (4) comprend une épitaxie de SiGe.

8. Procédé de réalisation selon l'une des revendications précédentes, dans lequel l'épitaxie de la première couche (5) comprend une épitaxie de Si dopé P++.

9. Procédé de réalisation selon l'une des revendications précédentes, comprenant, avant l'amincissement du substrat, un enrobage (11) des premiers composants (10) et de la partie d'interconnexion avec au moins un matériau isolant, et une fixation d'un deuxième substrat (12) sur l'enrobage (11) de matériau isolant.

10. Procédé de réalisation selon l'une des revendications précédentes, comprenant après la deuxième gravure un dépôt d'une couche de passivation (13) sur la deuxième couche (4).

11. Procédé de réalisation selon la revendication 10, comprenant une réalisation de deuxièmes composants (14) sur la couche de passivation (13).

12. Procédé selon l'une des revendications précédentes, dans lequel la première couche (5) présente une sélectivité de gravure vis-à-vis de la deuxième couche (4) comprise entre 30 et 500, de préférence entre 90 et 120.

13. Dispositif microélectronique comprenant une couche semiconductrice (3), une couche superficielle (4) formée sur une première face de la couche semiconductrice, des premiers composants (10) et une partie d'interconnexion situés au niveau et au dessus d'une deuxième face de la couche semiconductrice (3).

14. Dispositif microélectronique selon la revendication 13, dans lequel la couche semiconductrice (3) présente une épaisseur comprise entre 2 µm et 6 µm.

15. Dispositif microélectronique selon l'une des revendications 13 à 14, dans lequel la couche superficielle (4) comprend une couche de SiGe.

16. Dispositif microélectronique selon la revendication 13 à 15, dans lequel les premiers composants (10) comprennent des composants optoélectroniques destinés à être illuminés à travers la couche semiconductrice (3) et la couche superficielle (4).

17. Dispositif microélectronique selon l'une des revendications 13 à 16, dans lequel les premiers composants (10) et la partie d'interconnexion sont enrobés dans au moins un matériau isolant, un deuxième substrat (12) étant fixé sur l'enrobage isolant (11).

18. Dispositif microélectronique selon l'une des revendications 13 à 17, comprenant une couche de passivation (13) sur la couche superficielle (4).

19. Dispositif microélectronique selon la revendication 18, comprenant des deuxièmes composants (14) sur la couche de passivation (13).

20. Dispositif microélectronique selon la revendication 19, dans lequel les deuxièmes composants (14) comprennent des composants optiques.

21. Capteur d'image comprenant un dispositif selon l'une des revendications 13 à 20, destiné à être illuminé par la face arrière.
